# EUROPEAN PATENT APPLICATION

(11) **EP 4 440 278 A1**
(43) Date of publication of application: **02.10.2024**
(21) Application number: 24164262.8
(22) Date of filing: 18.03.2024
(51) Int. Cl.: H10K 30/40, H10K 30/86, H10K 71/16

(54) **HOLE TRANSPORT LAYER, PREPARATION METHOD THEREOF, AND PEROVSKITE SOLAR CELL**

(30) Priority: 21.03.2023 CN 202310276080
(71) Applicant: SolidEdge Solution Inc., Hsinchu 300 (TW)
(72) Inventor: CHEN, WEI-CHAO, Hsinchu City 300 (TW); CHEN, LIANG-YU, Hsinchu City 300 (TW); LAI, HONG-ZHENG, Hsinchu City 300 (TW); CHANG, TSENG-LUNG, Hsinchu City 300 (TW)
(74) Representative: Zaboliene, Reda

(57) **Abstract**

A method for preparing a hole transport layer of a perovskite solar cell, comprises S11, providing a conductive substrate; and S12: doping silver, gallium, selenium and sulfur with each other on the conductive substrate to obtain a hole transport layer. The present disclosure further provides a hole transport layer of a perovskite solar cell and a perovskite solar cell.

## Description

### CROSS-REFERENCE TO RELATED APPLICATIONS

This application claims all benefits from the Chinese Patent Application No. 202310276080.2, filed on March 21, 2023, in the China National Intellectual Property Administration, the disclosure of which is incorporated herein by reference.

### FIELD

The present disclosure relates to a field of perovskite solar cells, and in particular to a hole transport layer of a perovskite solar cell and a preparation method thereof, as well as a perovskite solar cell using the hole transport layer.

### BACKGROUND

Perovskite solar cells are solar cells that use perovskite-type organic metal halide semiconductors as light-absorbing materials. In recent years, perovskite solar cells have been extensively studied by the scientific community due to their high photoelectric performance, low cost and low pollution.

Chalcopyrite material can be used as a hole transport layer in perovskite solar cells due to its adjustable energy level (1.05-2.3 eV). When the hole transport layer comprises nano-chalcopyrite particles, the transport of electrons in the perovskite solar cell only relies on the hopping behavior between the nano-chalcopyrite particles in the hole transport layer. When preparing the perovskite solar cell, if the coating of the nano-chalcopyrite particles is too thick, due to the poor conductivity of the chalcopyrite material, it will affect the conductivity of the hole transport layer, thereby affecting the entire perovskite. Solar cell performance. If the coating of the nano-chalcopyrite particles is too thin, the surface of the perovskite absorption layer cannot be completely covered by the nano-chalcopyrite particles, and the perovskite absorption layer and the lower electrode may be in direct contact, resulting in significant localized. The circuit short-circuit behavior and further loss of moisture barrier properties will affect the normal use of perovskite solar cells.

### BRIEF DESCRIPTION OF THE DRAWINGS

In order to illustrate the technical solutions of the embodiments of the present application more clearly, the accompanying drawings in the embodiments will be briefly introduced below. It should be understood that the following drawings only show some embodiments of the present application, and therefore should not be seen as limiting the scope. For one of ordinary skill in the art, other related drawings can also be obtained from these drawings without any creative work.
FIG. 1 is a schematic structural diagram of a perovskite solar cell provided by the present disclosure.
FIG. 2 shows relative energy band positions of each component in a perovskite solar cell.
FIG. 3 shows a contact angle test of AgGa(Se, S)₂ film deposited on a transparent conductive oxide substrate (ITO).
FIG. 4 shows an X-ray diffraction patterns of sample 1, sample 2, ITO and chalcopyrite structure standard card number.
FIG. 5 is a Tauc Plot based on transmission and reflection spectral datas of the AgGa(Se, S)₂ film.
FIG. 6 is a voltage-current change trend diagram of AgGa(Se, S)₂ film deposited on molybdenum or ITO.

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the embodiments described herein. However, it will be understood by those of ordinary skill in the art that the embodiments described herein can be practiced without these specific details. In other instances, methods, procedures, and components have not been described in detail so as not to obscure the related relevant feature being described. The drawings are not necessarily to scale, and the proportions of certain parts may be exaggerated better illustrate details and features. The description is not to be considered as limiting the scope of the embodiments described herein.

The term "outside" refers to a region that is beyond the outermost confines of a physical object. The term "inside" indicates that at least a portion of a region is partially contained within a boundary formed by the object. The term "substantially" is defined to essentially conforming to the particular dimension, shape or other word that substantially modifies, such that the component need not be exact. For example, substantially cylindrical means that the object resembles a cylinder, but can have one or more deviations from a true cylinder. The term "comprising" means "including, but not necessarily limited to"; it specifically indicates open-ended inclusion or membership in a so-described combination, group, series and the like. It should be noted that references to "an" or "one" embodiment in this disclosure are not necessarily to the same embodiment, and such references mean at least one.

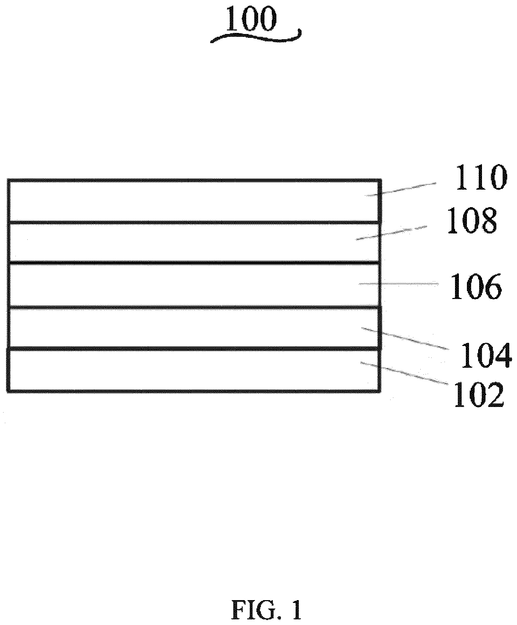

Referring to FIG. 1, one embodiment of the present disclosure provides a method for preparing a hole transport layer of a perovskite solar cell, which comprises the following steps:
S11, providing a conductive substrate; and
S12: doping silver, gallium, selenium and sulfur with each other on the conductive substrate to obtain a hole transport layer.

In step S11, the conductive substrate can be an electrode of a perovskite solar cell. In some embodiments, the conductive substrate can be a transparent substrate, such as ITO (indium tin oxide), carbon nanotubes, etc.

In step S12, the silver, gallium and selenium are arranged on the conductive substrate by a method of evaporation, sputtering, ion plating, etc. In one embodiment, a process of doping silver, gallium, selenium and sulfur with each other comprises the following steps:
S121, evaporating or sputtering silver, gallium, and selenium, on the conductive substrate at the same time to obtain an AgGaSe₂ film in a vacuum environment; and
S122: applying hydrogen sulfide gas on the AgGaSe₂ film to dope the AgGaSe₂ film with sulfur to obtain the hole transport layer under protective gas.

In step S121, a Vacuum degree of the vacuum environment is less than 10⁻⁶ torr. In one embodiment, the conductive substrate is ITO, a temperature of the ITO substrate is greater than or equal to 500 degrees (°C), and the AgGaSe₂ film is directly formed on the ITO. The temperature of the conductive substrate (such as ITO) must be greater than or equal to 500°C to make sure that the AgGaSe₂ film synthesized has a high quality. The AgGaSe₂ film is located on the conductive substrate.

In step S122, the protective gas is an inert gas such as argon. In one embodiment, a mixed gas of a certain concentration of hydrogen sulfide and argon is passed into the AgGaSe₂ film at a temperature of 550 °C to perform doping for a short time. In addition to the element Ag and the element Ga, the hole transport layer also contains Se and S. Therefore, the composition of the hole transport layer is AgGa(Se, S)₂.

Furthermore, by adjusting the temperature, time and concentration, a ratio of sulfur and selenium in the nanofilm is changed to control the film energy gap and the positions of HOMO (highest occupied molecular orbital) and LUMO (lowest unoccupied molecular orbital). Specifically, when AgGaS₂₋ₓSeₓ (where 0<X<2) the energy band (Eg) changes to Eg = 2.26*(1-X) + 1.76X, wherein 0<X<2; the HOMO position changed from X= -5.37 eV at 2 to -5.57 eV at X=0; and the LUMO position changes from -3.61eV at X=2 to -3.31eV at X=0. That is, the energy band of the hole transport layer and the positions of HOMO and LUMO can be controlled by adjusting the ratio of sulfur and selenium. A ratio of the hydrogen sulfide gas to the protective gas is in a range from 1:2 to 4:1. As the temperature increases (from 500°C to 650°C), the reaction time becomes longer (from 10 minutes to 60 minutes), the higher the ratio of hydrogen sulfide to argon becomes higher (4:1, 3:1, 2:1, 1:1, or 1:2), the and higher the ratio of sulfur to selenium.

In addition, sulfur powder can be vaporized at a high temperature to form sulfur vapor, and the sulfur vapor can be mixed with an inert gas such as argon to perform sulfur doping on the AgGaSe₂ film.

In another embodiment, a process of doping silver, gallium, selenium and sulfur with each other comprises the following steps:
first, evaporating or sputtering silver and gallium on the conductive substrate simultaneously in a vacuum environment to obtain an Ag/Ga alloy. The Ag/Ga alloy is an alloy of silver (Ag) and gallium (Ga).
second, sintering the Ag/Ga alloy and metallic selenium at a temperature in a hydrogen sulfide environment under a protective gas, the temperature is in a range of 500 °C to 650 °C, so that the Ag/Ga alloy is doped with mixed sulfur to obtain the hole transport layer. In this embodiment, the temperature is 600°C. The Ag/Ga alloy and metallic selenium sintered in the hydrogen sulfide environment under the protective gas is a process of sulfur-selenizing the Ag/Ga alloy.

In yet another embodiment, the process of doping silver, gallium, selenium and sulfur with each other comprises the following steps:
first, dissolving Ag/Ga alloy particles in a solvent to form a colloid and coating the colloid on the conductive substrate to obtain an Ag/Ga alloy film;
second, sintering the Ag/Ga alloy and metallic selenium at a temperature in a hydrogen sulfide environment under a protective gas, the temperature is in a range of 500 °C to 650 °C, so that the Ag/Ga alloy is doped with mixed sulfur to obtain the hole transport layer.

The present disclosure further provides a hole transport layer prepared by the method for preparing a hole transport layer of a perovskite solar cell disclosed above. The hole transport layer contains four elements: silver (Ag), gallium (Ga), selenium (Se) and sulfur (S), a molar ratio between silver, gallium, selenium and sulfur is: Ag: Ga: Se: S=1:1:2-X:X, wherein 0<X< 2. Therefore, the composition of the hole transport layer is AgGa(Se, S)₂.

Referring to FIG. 1, the present disclosure further provides a perovskite solar cell 100. The perovskite solar cell 100 comprises a first electrode 102, a hole transport layer 104, a perovskite layer 106, an electron transport layer 108 and a second electrode 110 that are stacked in sequence.

The materials of the first electrode 102 and the second electrode 110 are not limited, and can be gold, platinum, molybdenum, aluminum, copper and other metals or metal alloys. In some embodiments, in order to ensure light transmittance, the first electrode 102 and the second electrode 110 can be transparent electrodes. In one embodiment, the first electrode 102 and the second electrode 110 are transparent conductive oxide layers, such as ITO. In another embodiment, the first electrode 102 and the second electrode 110 are transparent electrodes made of fluorine-doped tin oxide (FTO).

The hole transport layer 104 is any one of the hole transport layer of the perovskite solar cell disclosed above. That is, the composition of the hole transport layer 104 is AgGa(Se, S)₂. The hole transport layer 104 has a thickness ranged from 30 nanometers to 100 nanometers. In some embodiments, the hole transport layer 104 has a thickness ranged from 50 nanometers to 70 nanometers.

The material of the perovskite layer 106 is organic-inorganic metal halide perovskite (FAₓMA_{y}Cs_{z})Pb(I_{α}Br_{β}Cl_{γ})₃, wherein X+Y+Z=1 and α+β+γ=1. In one embodiment, X:Y:Z=0:1:0 and α:β:γ=1:0:0, MAPbI₃ with simple composition can be obtained. In another embodiment, X:Y:Z=0:1:0 and α:β:γ=1:0:0, FAPbI₃ with a broad absorption spectrum can be obtained. In yet another embodiment, X:Y:Z=0.80:0.16:0.04 and α:β:γ=0.83:0.17:0, FA_{0.83}MA_{0.17}PbI_{2.49}Br_{0.51} with a broad absorption spectrum and stable crystal phase can be obtained.

For transporting electrons, a material of the electron transport layer 108 is at least one selected from carbon 60 derivatives, Bathocuproine BCP, titanium dioxide (TiO₂) and zinc oxide (ZnO). In a one embodiment, the electron transport layer 108 is made of TiO2. In another embodiment, the electron transport layer 108 is carbon 60 derivatives layered structure and bathocalin layered structure overlapped with each other.

The perovskite layer 106 will generate electrons and holes after absorbing sunlight. The electrons are transferred to the second electrode 110 through the electron transport layer 108 and collected by the second electrode 110; the holes are conducted through the hole transport layer 104 to the first electrode 102 and is collected by the first electrode 102, thereby realizing conversion of sunlight into electrical energy.

The present disclosure further provides a method for preparing the perovskite solar cell 100, which comprises the following steps:
S41, doping silver, gallium, selenium with sulfur on the first electrode 102 to obtain the hole transport layer 104;
S42, applying the perovskite layer 106 on a surface of the hole transport layer 104 away from the first electrode 102;
S43, applying the electron transport layer 108 on a surface of the perovskite layer 106 away from the hole transport layer 104; and
S44, applying the second electrode 110 on a surface of the electron transport layer 108 away from the perovskite layer 106.

Step S41 is the same as the preparation method of the hole transport layer described above. In one embodiment, the conductive substrate can be made of a material of the first electrode 102.

In step S42, in one embodiment, the perovskite layer 106 is a (FAₓMA₁₋ₓ)PbI₃ film, and a two-step solution method is used to prepare the (FAₓMA₁₋ₓ)PbI₃ film, which comprises steps of:
first, prepare a two-step precursor solution: dissolving lead iodide (PbI2) powder in a mixed solution of N, N dimethylformamide (DMF) and dimethyl sulfoxide (DMSO) (volume ratio 2:1 to 9:1), to obtain a lead iodide precursor solution with a concentration ranged from 1.0M to 1.5M; dissolving iodoformamidine (CH(NH₂)₂I) and iodomethylamine (CH₃NH₃I) powder in isopropyl alcohol (IPA), and a 0.7M amine salt precursor solution was obtained.
Second, preparing the (FAₓMA₁₋ₓ)PbI₃ film: first spin-coating the lead iodide precursor solution on the hole transport layer 104, and annealing at 70°C after the spin-coating is completed to obtain a lead iodide film, and then the amine salt precursor solution is spin-coated on the lead iodide film, and after the spin-coating is completed, the film is annealed at a temperature ranged 70°C to 120°C to obtain the (FAₓMA₁₋ₓ)PbI₃ film.

In step S43, spin-coating sintering, sputtering sintering, etc. can be used to form the electron transport layer 108, or the previously prepared electron transport layer 108 can be directly laid on the perovskite layer 106 away from the hole transport layer 104 surface.

In step S44, the second electrode 110 can be formed by vacuum evaporation, solution spin coating, or other methods, or the pre-prepared second electrode 110 can be directly laid on the electron transport layer 108 away from the perovskite layer 106. surface.

When the first electrode 102 and the second electrode 110 are both transparent conductive materials, for example, when both are transparent conductive oxide layers, sunlight can be irradiated from above and below the perovskite solar cell 100 and reach the mineral layer 106.

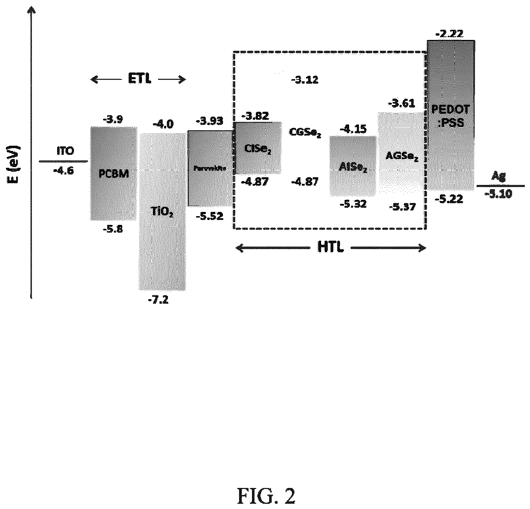

Since the hole transport layer 104 needs to be hydrophilic, this is beneficial to reducing the potential energy barrier in the perovskite nucleation process (the potential energy barrier refers to the potential energy required for perovskite nucleation), and can improve the coverage of the perovskite precursor solution on the hole transport layer 104. And the operating mechanism of the open circuit voltage of the perovskite solar cell 100 is determined by the HOMO (highest occupied molecular orbital) energy level of the hole transport layer 104 and the LUMO (lowest unoccupied molecular orbital) energy level of the electron transport layer 108, as shown in FIG. 2. In FIG. 2, "ITO" refers to indium tin oxide, "ETL" refers to the electron transport layer, "HTL" refers to the hole transport layer, and "PEDOT:PSS" refers to poly(3,4-ethylene dioxythiophene)-polystyrenesulfonate perovskite layer, "Ag" refers to silver. Therefore, typical copper-based alloy chalcopyrite materials (such as CuInSe₂ or CuGaSe₂) are not suitable for use as the hole transport layer 104 of the perovskite solar cell 100 because of the HOMO energy level of the copper-based alloy chalcopyrite materials is far different from the HOMO energy level of perovskite.

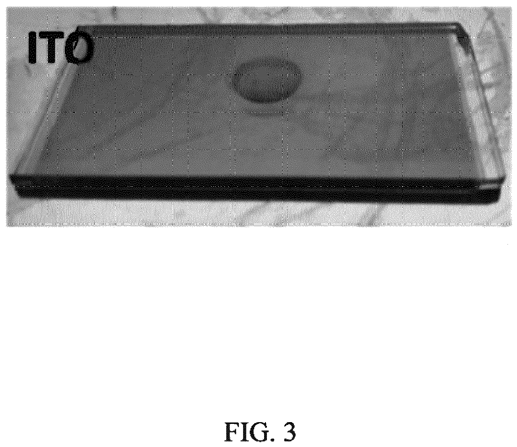

In the hole transport layer 104, the doping or presence of metallic gallium will expand the energy gap of the hole transport layer 104, and mainly contributes to the upward shift of the LUMO energy level. At the same time, the doping or presence of metallic silver will simultaneously reduce the energy gap of the hole transport layer 104. The HOMO and LUMO energy levels of the hole transport layer 104 have little impact on the energy gap. Therefore, the present disclosure uses AgGa(Se, S)₂ as the hole transport layer 104. An AgGa(Se, S)₂ film is formed on ITO, and a drop of water is placed on the AgGa(Se, S)₂ film, and the surface contact angle between the water drop and the AgGa(Se, S)₂ film is less than 90 degrees, as shown in FIG. 3. Therefore, the AgGa(Se, S)₂ film surface has high hydrophilicity and is suitable as a substrate for perovskite coatings. That is to say, since the perovskite precursor solution has a low surface energy, in the process of forming the perovskite layer 106, the precursor solution is spin-coated on a surface of the hydrophilic AgGa(Se, S)₂ film (ie, the hole transport layer 104 ), which is conducive to reducing the potential energy barrier in the perovskite nucleation process and is conducive to the formation of the perovskite layer 106.

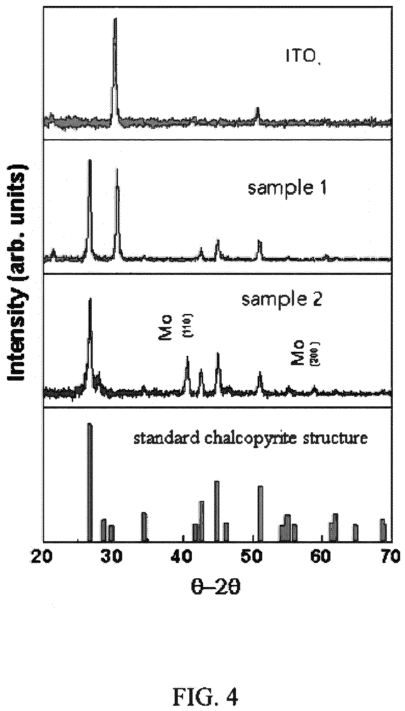

In one embodiment, in a high vacuum environment (<10⁻⁶ torr), a vacuum evaporator is used to simultaneously evaporate three metal source of silver (Ag), gallium (Ga) and selenium (Se) on the substrate metal molybdenum (substrate temperature is about 550°C) to form an AgGa(Se, S)₂ film (used as the hole transport layer 104). When ITO is used as the substrate, an AgGa(Se, S)₂ film/ITO is formed, which is recorded as sample 1. When metal molybdenum is used as the substrate, the AgGa(Se, S)₂ film/metal molybdenum formed is recorded as sample 2. FIG. 4 is the X-ray diffraction pattern of sample 1, sample 2, ITO and standard chalcopyrite structure. As can be seen from FIG. 4, typical diffraction peaks representing the chalcopyrite structure appear in the X-ray diffraction patterns of samples 1 and 2, indicating that the AgGa(Se, S)₂ film is a good quality chalcopyrite nanofilm.

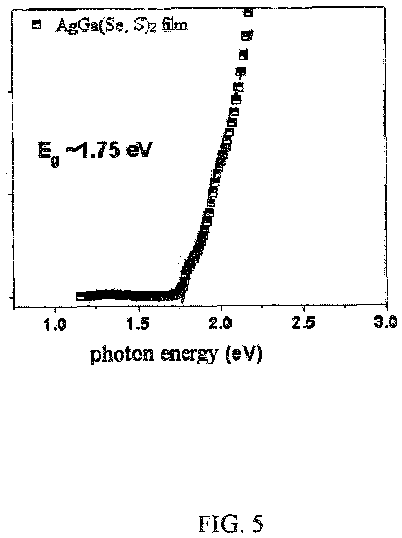

FIG. 5 is a Tauc plot (Tauc Plot) drawn based on the transmission and reflection spectrum data of the AgGa(Se, S)₂ film. The Tauc plot is a plot obtained by obtaining the semiconductor energy bandwidth from the absorption spectrum. In FIG. 5, the light given by the measuring instrument has a wavelength ranged from 300 nanometers to 1300 nanometers, and the AgGa(Se, S)₂ film is passed through the wavelength of this band to obtain the absorption intensity of the film corresponding to the wavelength, the transmission and reflection spectral data of the AgGa(Se, S)₂ film is obtained, and then drawing a Tauc Plot based on the spectral data, and accurately calculate the energy gap of the AgGa(Se, S)₂ film to be 1.75 eV, which is in good agreement with the theoretical calculation results (~1.8 eV). Further, the energy gap of the hole transport layer is at least 1.75 eV

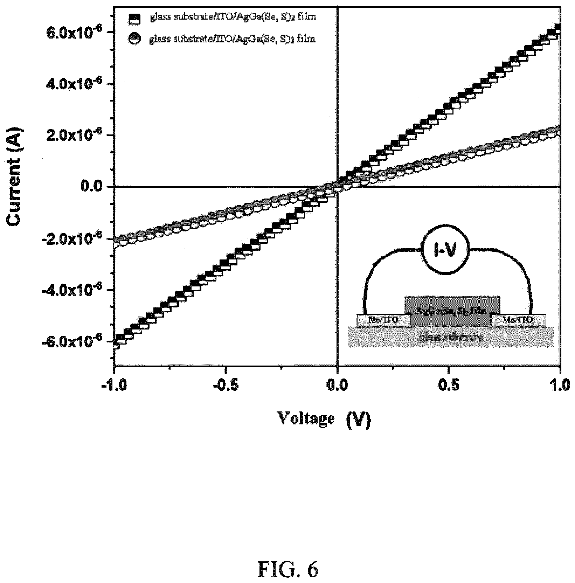

As shown in FIG. 6, through Ohmic contact electrical test observation, whether the AgGa(Se, S)₂ film is deposited on a transparent conductive oxide substrate (such as ITO) or on a metal substrate (such as metal molybdenum), in a voltage ranged from -1 volt to 1 volt, the current shows a linear increase, which shows that the surface contact between the AgGa(Se, S)₂ film and the transparent conductive oxide substrate, and the surface contact between the AgGa(Se, S)₂ film and the transparent conductive oxide substrate, are both Ohmic contact. In FIG. 6, "glass substrate" refers to glass, which is used to carry the first electrode 102; "ITO" and "molybdenum" are used as the first electrode 102; "chalcopyrite film" refers to the AgGa(Se, S)₂ film. From the above experiments, it can be confirmed that, the AgGa(Se, S)₂ film can be used as the hole transport layer 104 of the perovskite solar cell 100 in terms of crystal structure, optics and electricity.

The embodiments shown and described above are only examples. Even though numerous characteristics and advantages of the present technology have been set forth in the foregoing description, together with details of the structure and function of the present disclosure, the disclosure is illustrative only, and changes may be made in the detail, including in matters of shape, size, and arrangement of the parts within the principles of the present disclosure, up to and including the full extent established by the broad general meaning of the terms used in the claims.

Depending on the embodiment, certain of the steps of methods described may be removed, others may be added, and the sequence of steps may be altered. The description and the claims drawn to a method may comprise some indication in reference to certain steps. However, the indication used is only to be viewed for identification purposes and not as a suggestion for ordering the steps.

## Claims

1. A method for preparing a hole transport layer of a perovskite solar cell, comprising steps of:
providing a conductive substrate; and
forming a hole transport layer within doping silver, gallium, selenium and sulfur with each other onto the conductive substrate.

2. The method of claim 1, wherein the steps of forming the hole transport layer comprises:
evaporating or sputtering silver, gallium and selenium on the conductive substrate simultaneously to obtain an AgGaSe₂ film in a vacuum environment; and
applying a hydrogen sulfide gas and a protective gas to dope the AgGaSe₂ film with sulfur to obtain the hole transport layer.

3. The method of claim 2, wherein a ratio of the hydrogen sulfide gas to the protective gas is in a range from 1:2 to 4:1.

4. The method of claim 2, wherein evaporating or sputtering silver, gallium and selenium on the conductive substrate is at a temperature ranged from 500 °C to 650 °C.

5. The method of claim 1, wherein a process of forming the hole transport layer comprises:
evaporating or sputtering silver and gallium on the conductive substrate simultaneously in a vacuum environment to obtain an Ag/Ga alloy film; and
co-sintering the Ag/Ga alloy film and metallic selenium with a hydrogen sulfide gas and a protective gas at a temperature ranged from 500 °C to 650 °C.

6. The method of claim 1, wherein a process of forming the hole transport layer comprises:
dissolving Ag/Ga alloy particles in a solvent to form a colloid and coating the colloid on the conductive substrate to obtain an Ag/Ga alloy film;
co-sintering the Ag/Ga alloy film and metallic selenium with a hydrogen sulfide gas and a protective gas at a temperature ranged from 500 °C to 650 °C.

7. The method of claim 6, wherein a particle size of the Ag/Ga alloy particles is in a range from 20nm to 30nm.

8. A hole transport layer of a perovskite solar cell, comprising silver, gallium, selenium and sulfur, wherein a composition of the hole transport layer is AgGa(Se, S)₂, and a molar ratio between silver, gallium, selenium and sulfur is 1:1:2-X:X, 0<X<2.

9. The hole transport layer of claim 8, wherein an energy gap of the hole transport layer is at least 1.75 eV.

10. The hole transport layer of claim 8, wherein the hole transport layer has a thickness ranged from 30 nm to 100 nm.

11. The hole transport layer of claim 8, wherein an energy band of the hole transport layer is defined as Eg, and Eg satisfies Eg = 2.26*(1-X) + 1.76 X, 0<X<2.

12. A perovskite solar cell, comprising a first electrode, a hole transport layer, a perovskite layer, an electron transport layer and a second electrode stacked in sequence, wherein the hole transport layer comprises silver, gallium, selenium and sulfur, a composition of the hole transport layer is AgGa(Se, S)₂, and a molar ratio between silver, gallium, selenium and sulfur is 1:1:2-X:X, 0<X<2.

13. The perovskite solar cell of claim 12, wherein a material of the electron transport layer is at least one selected from carbon 60 derivatives, Bathocuproine BCP, titanium dioxide (TiO₂) and zinc oxide (ZnO).

14. The perovskite solar cell of claim 12, wherein an energy band of the hole transport layer is defined as Eg, and Eg satisfies Eg = 2.26*(1-X) + 1.76 X, 0<X<2.

15. The perovskite solar cell of claim 12, wherein the first electrode and the second electrode are transparent electrodes.
